# EUROPEAN PATENT APPLICATION

(11) **EP 3 813 131 A1**
(43) Date of publication of application: **28.04.2021**
(21) Application number: 19822480.0
(22) Date of filing: 07.06.2019
(51) Int. Cl.: H01L 41/317, H01L 41/187

(54) **LIQUID COMPOSITION FOR FORMING KNN FILM AND METHOD FOR FORMING KNN FILM USING SAID LIQUID COMPOSITION**

(30) Priority: 22.06.2018 JP 2018118737
(71) Applicant: Mitsubishi Materials Corporation, Tokyo 100-8117 (JP)
(72) Inventor: TSUJIUCHI Naoto, Naka-shi, Ibaraki 311-0102 (JP); DOI Toshihiro, Naka-shi, Ibaraki 311-0102 (JP); SOYAMA Nobuyuki, Naka-shi, Ibaraki 311-0102 (JP)
(74) Representative: Gille Hrabal Partnerschaftsgesellschaft mbB Patentanwälte
(86) International application number: PCT/JP2019/022748
(87) International publication number: WO 2019/244673

(57) **Abstract**

This liquid composition for forming a KNN film includes an organic metal compound including an organic potassium compound, an organic sodium compound, and an organic niobium compound, and a solvent. In this liquid composition for forming a KNN film, the organic potassium compound and the sodium compound are each metal salts of a carboxylic acid represented by General Formula CₙH₂ₙ₊₁COOH (here, 4≤n≤8), the organic niobium compound is a niobium alkoxide or a metal salt of a carboxylic acid represented by General Formula CₙH₂ₙ₊₁COOH (here, 4≤n≤8), and a main solvent is a carboxylic acid represented by General Formula CₙH₂ₙ₊₁COOH (here, 4≤n≤8) and is included in an amount of 50% by mass to 90% by mass with respect to 100% by mass of the liquid composition for forming a KNN film.

## Description

### TECHNICAL FIELD

The present invention relates to a liquid composition for forming a KNN film which does not include lead and which is able to form a dense film, and a method for forming a KNN film using this liquid composition. In the present specification, KNN is an abbreviation for potassium sodium niobate ((K, Na)NbO₃).

The present application claims priority based on Japanese Patent Application No. 2018-118737 filed in Japan on June 22, 2018, and the content thereof is incorporated herein.

### BACKGROUND ART

Up to now, PZT (lead zirconate titanate) having high piezoelectric characteristics has been used as a piezoelectric layer of a piezoelectric element mounted in devices known as MEMS (Micro Electro Mechanical Systems) such as an actuator or an ultrasonic device. However, from the environmental point of view, there is a demand for the development of piezoelectric materials in which the lead content is suppressed. As one such piezoelectric material, a piezoelectric material made of KNN is being developed.

In the related art, liquid compositions which are a piezoelectric material formed of KNN include metal complex mixtures including potassium, sodium, and niobium, silicone oil, and a solvent, in which 5 parts by volume or less of silicone oil are included in 100 parts by volume of the total amount of the metal complex mixture and the solvent. Including a predetermined amount of silicone oil makes it possible for this liquid composition to suppress thermal expansion in a firing step when forming a piezoelectric ceramic film so as to reduce residual stress in the piezoelectric ceramic film and use thereof is possible as a composition for forming a piezoelectric ceramic film (for example, refer to Patent Document 1).

The metal complex mixtures described above are prepared by dissolving and dispersing these metal complexes in a solvent such that each of the metals of potassium (K), sodium (Na) and niobium (Nb) has a desired molar ratio. Examples of the metal complex including K include potassium 2-ethyl hexanoate, potassium acetate, potassium acetylacetonate, potassium ethoxide, and the like. Examples of the metal complex including Na include sodium 2-ethyl hexanoate, sodium acetate, sodium acetylacetonate, sodium ethoxide, and the like. Examples of the metal complex including Nb include niobium ethoxide, niobium 2-ethyl hexanoate, niobium pentaethoxide, and the like. In addition, examples of the solvent described above include various solvents such as toluene, xylene, octane, ethylene glycol, 2-methoxyethanol, butanol, ethanol, isopropyl alcohol, acetic acid, and water.

### Citation List

### Patent Document

Patent Document 1: Japanese Unexamined Patent Application, First Publication No. 2012-169467 (Abstract, paragraph [0023], paragraph [0025])

### SUMMARY OF INVENTION

### Technical Problem

Up to now, KNN films have been formed by coating and drying a liquid composition of this type on an electrode of a substrate by a chemical solution deposition (CSD) method, carrying out pre-firing, and then carrying out firing. However, as shown in Patent Document 1, in a case of using one type or more selected from toluene, xylene, octane, ethylene glycol, 2-methoxyethanol, butanol, ethanol, isopropyl alcohol, acetic acid, and water as a solvent to form the KNN film, there is a problem in that it is difficult to obtain a dense film.

An object of the present invention is to provide a liquid composition for forming a KNN film which does not include lead and which is able to form a dense film, and a method for forming a KNN film using this liquid composition.

### Solution to Problem

The present inventors found that, in the CSD method, in a case in which, in addition to using a specific carboxylic acid salt as a metal compound of a liquid composition as a solvent of a liquid composition for forming a KNN film, a specific carboxylic acid is also used as a main solvent, the peak of the exothermic reaction is large when the liquid composition is decomposed and it is possible to solve the problems described above, thereby completing the present invention.

The first aspect of the present invention is a liquid composition for forming a KNN film including an organic metal compound including an organic potassium compound, an organic sodium compound, and an organic niobium compound, and a solvent, in which the organic potassium compound and the organic sodium compound are each a metal salt of a carboxylic acid represented by General Formula CₙH₂ₙ₊₁COOH (here, 4≤n≤8), the organic niobium compound is a niobium alkoxide or a metal salt of a carboxylic acid represented by General Formula CₙH₂ₙ₊₁COOH (here, 4≤n≤8), and a main solvent in the solvent is a carboxylic acid represented by General Formula CₙH₂ₙ₊₁COOH (here, 4≤n≤8) and a content of the main solvent is 50% by mass to 90% by mass with respect to 100% by mass of the liquid composition.

A second aspect of the present invention is a method for forming a KNN film, including coating an electrode of a substrate with the liquid composition for forming a KNN film based on the first aspect, followed by performing pre-firing at a temperature of 150°C or higher and 350°C or lower to form a pre-fired film, and heating the pre-fired film at a rate of 10°C/second or more to carry out firing at a temperature of 600°C or higher and 800°C or lower, thereby forming a crystallized KNN film.

### Advantageous Effects of Invention

With the liquid composition for forming a KNN film of the first aspect of the present invention, by using a specific carboxylic acid as a metal compound as a raw material species and, with regard to the solvent, further setting this specific carboxylic acid as a main solvent, the exothermic reaction peak is large when a liquid composition is decomposed, the liquid composition is fired instantly, and it is possible to form a dense KNN film in which the residual carbon is small.

In the method for forming a KNN film of the second aspect of the present invention, after coating the liquid composition for forming a KNN film, pre-firing is carried out at a predetermined temperature to form a pre-fired film, the pre-fired film is heated at a rate of 10°C/second or more, and the firing is performed in a batch at a temperature of 600°C or higher and 800°C or lower. In this method, the coating film of the liquid composition is pre-fired at a predetermined temperature and fired at a predetermined heating rate, due to this, the exothermic reaction peak is large when the liquid composition is decomposed, the liquid composition is fired instantly, and it is possible to form a dense KNN film in which the residual carbon is small.

### BRIEF DESCRIPTION OF DRAWINGS

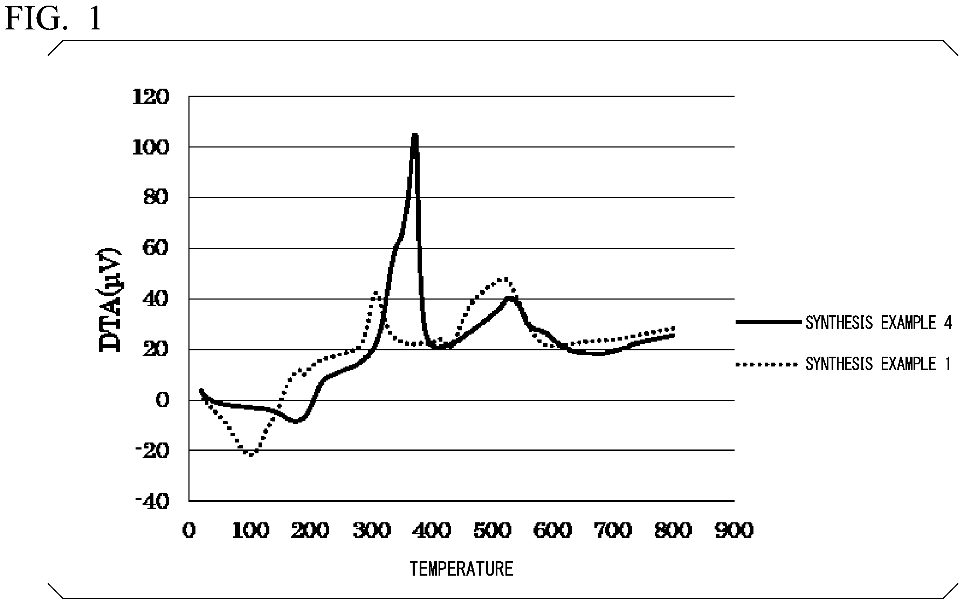

Fig. 1 is a graph showing the DTA measurement results when liquid compositions of Synthesis Example 4 and Synthesis Comparative Example 1 were heated under atmospheric pressure from room temperature to 800°C at 10°C/sec.

### DESCRIPTION OF EMBODIMENTS

A description will be given of embodiments for carrying out the present invention.

### [Liquid Composition for Forming KNN film]

The liquid composition for forming a KNN film of the present embodiment includes an organic metal compound including an organic potassium compound, an organic sodium compound, and an organic niobium compound, and a solvent. The KNN film formed from this liquid composition is formed of a complex oxide of an organic metal compound having a perovskite structure of potassium sodium niobate ((K, Na)NbO₃). The composite oxide according to the present embodiment includes potassium (K) and sodium (Na) at the A site and includes niobium (Nb) at the B site. In this perovskite-type ABO₃ type structure, at the A sites, oxygen is coordinated at 12 sites and, at the B sites, oxygen is coordinated at 6 sites to form an octahedron (octahedron), and potassium and sodium are positioned at the A sites and niobium is positioned at the B sites.

The metal molar ratio of the organic metal compound according to the present embodiment, that is, the composite oxide, is not particularly limited; however, K:Na:Nb is preferably x:1-x:y (here, 0.1≤x≤0.7 and 0.7≤y≤1.4). Here, when y is less than 0.7, there is a concern that the Nb source may be excessively small and cause a different phase, and when y is more than 1.4, there is a concern that the Nb source may be excessively large and cause a different phase.

The organic potassium compound and the organic sodium compound of the present embodiment are metal salts of carboxylic acids represented by General Formula CₙH₂ₙ₊₁COOH (here, 4≤n≤8). When n is less than 4, the film is not dense, and when n is more than 8, the main solvent will be solid and unsuitable as a solvent when the carboxylic acid is used as the main solvent as described below. n is preferably in the range of 6 to 8.

In addition, the organic niobium compound of the present embodiment is a niobium alkoxide or a metal salt of a carboxylic acid represented by General Formula CₙH₂ₙ₊₁ COOH (here, 4≤n≤8).

The carboxylic acid represented by General Formula CₙH₂ₙ₊₁COOH (here, 4≤n≤8) is specifically the compound shown in Table 1 below.

In a case where the organic potassium compound and the organic sodium compound are not metal salts of carboxylic acid, but are, for example, potassium alkoxide or sodium alkoxide, a different phase occurs in the process of forming a film from the liquid composition. The organic niobium compound may be a niobium alkoxide instead of a metal salt of carboxylic acid.

As niobium alkoxide, it is possible to use pentaethoxy niobium (also known as ethoxy niobium) or the like.

**[Table 1]**

| Number of n in CₙH₂ₙ₊₁COOH | Compound name of carboxylate |
|---|---|
| n=4 | α-methyl butyrate |
| | Isovaleric acid |
| n=5 | 2-ethyl butyrate |
| | 2,2-dimethyl butyrate |
| | 3,3-dimethyl butyrate |
| | 2,3-dimethyl butyrate |
| | 3-methyl pentanoate |
| | 4-methyl pentanoate |
| n=6 | 2-ethyl pentanoate |
| | 3-ethyl pentanoate |
| | 2,2-dimethyl pentanoate |
| | 2,3-dimethyl pentanoate |
| | 4-methyl hexanoate |
| n=7 | 2-ethyl hexanoate |
| | 3-ethyl hexanoate |
| | 2,2-dimethyl hexanoate |
| | 2,3-dimethyl hexanoate |
| n=8 | 2-propyl hexanoate |
| | 2-ethyl heptanoate |
| | Pelargonic acid |

In the solvent included in the liquid composition for forming a KNN film of the present embodiment, the main solvent is a carboxylic acid represented by General Formula CₙH₂ₙ₊₁COOH (here, 4≤n≤8). The carboxylic acid as a main solvent is included at 50% by mass to 90% by mass with respect to 100% by mass of the liquid composition, and preferably 70% by mass to 80% by mass. When the carboxylic acid as the main solvent is less than 50% by mass, there is a problem in that precipitation will occur during the preparation of the liquid composition, and when the carboxylic acid exceeds 90% by mass, there is a problem in that the formed film will be excessively thin and productivity will be reduced. Examples of the solvent other than the carboxylic acid represented by General Formula described above include alcohol, acetic acid, water, and the like.

Here, if the metal salt of a carboxylic acid that is an organic metal compound is a metal salt of 2-ethyl hexanoate such as, for example, potassium 2-ethyl hexanoate, sodium 2-ethyl hexanoate, and niobium 2-ethyl hexanoate, the main solvent also being 2-ethyl hexanoate means various types of by-products are not generated in the solution, which is preferable. That is, the carboxylic acid which forms the metal salt and the carboxylic acid of the main solvent are preferably of the same type.

### [Method for Preparing Liquid Composition for Forming KNN Film]

The liquid composition for forming a KNN film of the present embodiment is prepared by dissolving the organic potassium compound (K source), organic sodium compound (Na source), and organic niobium compound (Nb source) described above, which are metal sources of KNN, in a solvent including the main solvent described above. Specifically, first, by placing an organic solvent including a carboxylic acid as the solvent described above (including a stabilizer which is an organic solvent that can be eliminated by vacuum distillation described below) and an organic sodium compound in a container, and carrying out refluxing with an oil bath at 130°C to 170°C for 30 minutes to 60 minutes to obtain a reddish-brown suspension. An organic potassium compound and an organic niobium compound are added thereto, and refluxing is continued for 30 minutes to 60 minutes with an oil bath at the same temperature to prepare a synthesis liquid. Here, the organic potassium compound (K source), the organic sodium compound (Na source), and the organic niobium compound (Nb source) have weights with a metal molar ratio (K:Na:Nb) of x:1-x:y (here, 0.1≤x≤0.7, 0.7≤y≤1.4).

Next, the solvent is desorbed from the synthesis liquid by vacuum distillation to remove the organic solvent and reaction by-products. As necessary, carboxylic acid, alcohol, water, or the like as a solvent is added to the obtained solution, and the solution is diluted until the total amount of potassium, sodium, and niobium is 6% by mass to 20% by mass in terms of metal oxide. The obtained diluted solution is filtered with a filter to remove the residue and obtain a liquid composition. When the total amount of potassium, sodium, and niobium is less than 6% by mass in terms of metal oxide, a good film is obtained, but the film thickness is excessively thin, thus, the productivity deteriorates until the desired thickness is obtained. If the total amount exceeds 20% by mass, the liquid composition easily precipitates.

### [Method for Forming KNN film]

The KNN film of the present embodiment is formed on the substrate. This substrate has a heat-resistant substrate body made of silicon or sapphire. In a case of a substrate body made of silicon, a SiO₂ film is provided on this substrate body and a lower electrode made of a material having conductivity such as Pt, TiOx, Ir, and Ru, and which does not react with the KNN film is provided on the SiO₂ film. For example, it is possible for the lower electrode to have a two-layer structure of a TiOx film and a Pt film in order from the substrate body side. Specific examples of the TiOx film include a TiO₂ film. Further, the SiO₂ film is formed to improve the adhesion. The Pt film is formed to be oriented in the (111) plane by, for example, a sputtering method.

On the Pt film of this lower electrode, the liquid composition described above is coated by the CSD method, pre-fired, and fired to form a KNN film. The coating of the liquid composition is performed by spin coating, dip coating, a LSMCD (Liquid Source Misted Chemical Deposition) method, an electrostatic spray method, or the like, to form a coating film (gel film) having a thickness of 50 nm or more and 150 nm or less after pre-firing. If the film thickness after pre-firing is less than 50 nm, a good film is obtained, but since the film thickness is excessively thin, there is a problem in that productivity deteriorates until the desired thickness is obtained, while if the film thickness exceeds 150 nm, cracks are easily generated in the KNN film after firing.

The pre-firing after coating the liquid composition, for example, is performed by a hot plate or an infrared rapid thermal annealing furnace (RTA) at a temperature of 150°C or higher and 400°C or lower, and preferably 200°C or higher and 350°C or lower. If the pre-firing temperature is less than 150°C, there is a problem in that a gel form is not obtained. When the temperature exceeds 400°C, the KNN film does not crystallize easily. When the thickness of the pre-fired film after pre-firing is less than 50 nm, a good film is obtained, but since the film thickness is excessively thin, there is a problem in that productivity deteriorates until the desired thickness is obtained, while, if the thickness exceeds 150 nm, cracks are easily generated in the KNN film after firing.

After producing the pre-fired film, the pre-fired film is fired. This firing is performed by heating the pre-fired film to a temperature of 600°C or higher and 800°C or lower at a rate of 10°C/sec or more by RTA (Rapid Thermal Annealing) in an atmosphere including oxygen (O₂) and holding for a time of 0.5 minutes or more and 5 minutes or less. A preferable heating rate is 40°C/sec or more and 60°C/sec or less, and a preferable firing temperature is 650°C or higher and 750°C or lower. If the heating rate is less than 10°C/sec and the firing temperature is less than 600°C, the crystallinity of the produced KNN film is not sufficient and the density thereof is low. When the firing temperature exceeds 800°C, the substrate or the like will be damaged.

### Examples

Next, a detailed description will be given of Examples and Comparative Examples of the present invention.

### <Synthesis Example 1>

α-Methyl butyrate as a solvent, acetic anhydride as an additive, sodium α-methyl butyrate (Na source) as an organic sodium compound, and dimethyl succinate as a stabilizer were added to a flask at a molar ratio of 5:3:1:4 to prepare a suspension. Next, the obtained suspension in the flask was refluxed at 150°C for 30 minutes with an oil bath at 150°C. After the refluxing, potassium α-methylbutyrate (K source) as an organic potassium compound and niobium pentaethoxide (Nb source) as an organic niobium compound were added to the refluxed liquid, and refluxing was carried out at 150°C for 30 minutes with an oil bath at 150°C to prepare a synthesis liquid. Here, the potassium α-methylbutyrate (K source), the sodium α-methylbutyrate (Na source), and the niobium pentaethoxide (Nb source) were each weighed such that the metal molar ratio (K:Na:Nb) was 50:50:100. After the refluxing, water and ethanol were added to the refluxed liquid, and refluxing was performed again at 150°C for 30 minutes with an oil bath at 150°C. After the refluxing, distillation was carried out under reduced pressure to 0.015 MPa with an aspirator. Due to this, unreacted products were removed to obtain a liquid composition which was a KNN precursor. α-Methylbutyrate as a solvent was added to the liquid composition such that the concentration of metal oxides (potassium, sodium and niobium) in the liquid composition was 10% by mass so as to dilute the liquid composition. The content ratio of α-methylbutyrate as a main solvent was 70% by mass with respect to 100% by mass of the diluted liquid composition. The residue was removed by filtering the diluent through a filter.

Table 2 shows the type of organic metal compound (organic potassium compound, organic sodium compound, and organic niobium compound) with which the liquid composition of Synthesis Example 1 was prepared, the metal molar ratio (K:Na:Nb) in the liquid composition, the type of the main solvent, and, in a case where the main solvent is carboxylic acid, the number of n in General Formula CₙH₂ₙ₊₁COOH described above, and the content (% by mass) of the main solvent with respect to 100% by mass of the liquid composition.

**[Table 2]**

| Liquid composition for forming a KNN film | | | | | | | | | |
|---|---|---|---|---|---|---|---|---|---|
| Type | Type of organic metal compound | | | Metal molar ratio | | | Main solvent | | |
| | Organic K compound | Organic Na compound | Organic Nb compound | K | Na | Nb | Type | Number of n | Content (% by mass) |
| Synthesis example 1 | α-methyl butyrate K | α-methyl butyrate Na | Ethoxy Nb | 50 | 50 | 100 | α-methyl butyrate | 4 | 70 |
| Synthesis example 2 | 2-ethyl butyrate K | 2-ethyl butyrate Na | Ethoxy Nb | 50 | 50 | 100 | 2-ethyl butyrate | 5 | 70 |
| Synthesis example 3 | 2-ethyl pentanoate K | 2-ethyl pentanoate Na | Ethoxy Nb | 50 | 50 | 100 | 2-ethyl pentanoate | 6 | 70 |
| Synthesis example 4 | 2-ethyl hexanoate K | 2-ethyl hexanoate Na | Ethoxy Nb | 50 | 50 | 100 | 2-ethyl hexanoate | 7 | 70 |
| Synthesis example 5 | 2-propyl hexanoate K | 2-propyl hexanoate Na | Ethoxy Nb | 50 | 50 | 100 | 2-propyl hexanoate | 8 | 70 |
| Synthesis example 6 | 2-ethyl hexanoate K | 2-ethyl hexanoate Na | Ethoxy Nb | 50 | 50 | 100 | 2-ethyl hexanoate | 7 | 50 |
| Synthesis example 7 | 2-ethyl hexanoate K | 2-ethyl hexanoate Na | Ethoxy Nb | 50 | 50 | 100 | 2-ethyl hexanoate | 7 | 80 |
| Synthesis example 8 | 2-ethyl hexanoate K | 2-ethyl hexanoate Na | Ethoxy Nb | 50 | 50 | 100 | 2-ethyl hexanoate | 7 | 90 |
| Synthesis example 9 | 2-propyl hexanoate K | 2-propyl hexanoate Na | Ethoxy Nb | 50 | 50 | 100 | 2-ethyl hexanoate | 7 | 70 |
| Synthesis comparative example 1 | Acetic acid K | Acetic acid Na | Ethoxy Nb | 50 | 50 | 100 | Acetic acid | 2 | 70 |
| Synthesis comparative example 2 | 2-ethyl hexanoate K | 2-ethyl hexanoate Na | Ethoxy Nb | 50 | 50 | 100 | 2-ethyl hexanoate | 7 | 20 |
| Synthesis comparative example 3 | 2-ethyl hexanoate K | 2-ethyl hexanoate Na | Ethoxy Nb | 50 | 50 | 100 | 2-ethyl hexanoate | 7 | 98 |
| Synthesis comparative example 4 | K ethoxide | 2-ethyl hexanoate Na | Ethoxy Nb | 50 | 50 | 100 | 2-ethyl hexanoate | 7 | 70 |
| Synthesis comparative example 5 | 2-ethyl hexanoate K | Na ethoxide | Ethoxy Nb | 50 | 50 | 100 | 2-ethyl hexanoate | 7 | 70 |

### <Synthesis Examples 2 to 8 and Synthesis Comparative Examples 1 to 5>

Using organic potassium compounds, organic sodium compounds and organic niobium compounds, which are the organic metal compounds shown in Table 2, these organic metal compounds were weighed so as to have the metal molar ratio shown in Table 2, and the content of the main solvent was changed as shown in Table 2. Liquid compositions of Synthesis Examples 2 to 8 and Synthesis Comparative Examples 1 to 5 were prepared in the same manner as in Synthesis Example 1 except for the above. In Synthesis Comparative Example 4, potassium alkoxide was used as the organic potassium compound. In addition, in Synthesis Comparative Example 5, sodium alkoxide was used as the organic sodium compound.

### <Example 1>

Next, for evaluation, a KNN film was formed on the substrate using the liquid composition obtained in Synthesis Example 1. A 4-inch Si substrate was used as the substrate. A 500 nm oxide film was formed on the Si substrate by thermal oxidation. 20 nm of Ti was deposited on the oxide film by a sputtering method, and a Pt lower electrode of (111) orientation having a thickness of 100 nm was formed thereon by a sputtering method. 0.5 ml of the liquid composition obtained in Synthesis Example 1 was dropped on the obtained substrate, spin coating was performed at 5000 rpm for 15 seconds, and the spin coated liquid was dried. Furthermore, pre-firing was performed on a hot plate at 300°C for 5 minutes. After that, firing was performed by RTA at 700°C in an oxygen atmosphere at a temperature increase rate of 50°C/sec and a holding time of 1 minute. Due to this, the KNN film of Example 1 was formed on the lower electrode.

Table 3 shows the types of synthesis examples (Synthesis Example 1) which obtained the liquid composition used in Example 1, the pre-firing temperature, the heating rate, the firing temperature, and the holding time.

**[Table 3]**

| | KNN film-forming conditions | | | | | Evaluation of film |
|---|---|---|---|---|---|---|
| | Type of synthesis example obtaining liquid composition | Pre-firing temperature (°C) | Heating rate (°C/sec) | Firing temperature (°C) | Holding time (sec) | Denseness of film |
| Example 1 | Synthesis example 1 | 300 | 50 | 700 | 60 | Good |
| Example 2 | Synthesis example 2 | 300 | 50 | 700 | 60 | Good |
| Example 3 | Synthesis example 3 | 300 | 50 | 700 | 60 | Good |
| Example 4 | Synthesis example 4 | 300 | 50 | 700 | 60 | Excellent |
| Example 5 | Synthesis example 5 | 300 | 50 | 700 | 60 | Excellent |
| Example 6 | Synthesis example 6 | 300 | 50 | 700 | 60 | Good |
| Example 7 | Synthesis example 7 | 300 | 50 | 700 | 60 | Good |
| Example 8 | Synthesis example 8 | 300 | 50 | 700 | 60 | Good |
| Example 9 | Synthesis example 9 | 300 | 50 | 700 | 60 | Good |
| Example 10 | Synthesis example 7 | 150 | 50 | 700 | 60 | Good |
| Example 11 | Synthesis example 7 | 400 | 50 | 700 | 60 | Good |
| Example 12 | Synthesis example 7 | 300 | 10 | 600 | 60 | Good |
| Example 13 | Synthesis example 7 | 300 | 50 | 800 | 60 | Good |
| Comparative Example 1 | Synthesis example 1 | 300 | 50 | 700 | 60 | Poor |
| Comparative Example 2 | Synthesis example 2 | | | | | - |
| Comparative Example 3 | Synthesis example 3 | | | | | - |
| Comparative Example 4 | Synthesis example 4 | 300 | 50 | 700 | 60 | Poor |
| Comparative Example 5 | Synthesis example 5 | 300 | 50 | 700 | 60 | Poor |
| Comparative Example 6 | Synthesis example 7 | 140 | 50 | 700 | 60 | Poor |
| Comparative Example 7 | Synthesis example 7 | 450 | 50 | 700 | 60 | Poor |
| Comparative Example 8 | Synthesis example 7 | 300 | 9 | 550 | 60 | Poor |
| Comparative Example 9 | Synthesis example 7 | 300 | 50 | 850 | 60 | Poor |

### <Examples 2 to 12 and Comparative Examples 1 to 9>

Using the liquid compositions obtained in Synthesis Examples 2 to 9 and Synthesis Comparative Examples 1 to 5 and Synthesis Example 7 shown in Table 2, each of the liquid compositions was spin-coated in the same manner as in Example 1, dried, then the pre-firing temperature, the heating rate, the firing temperature, and the holding time were changed as shown in Table 3. Except for this, the KNN films of Examples 2 to 13 and Comparative Examples 1 to 9 were formed on the lower electrode in the same manner as in Example 1. In addition, in Comparative Example 2, precipitation occurred in the liquid, and in Comparative Example 3, it was not possible to uniformly coat the liquid composition, thus, it was not possible to form each film.

### <Comparative Test 1>

20 mg each of the liquid compositions synthesized in Synthesis Example 4 and Synthesis Comparative Example 1 was sampled on alumina plates and, using a thermogravimeter-differential thermal analyzer (TG-DTA) (manufactured by Mac Science, TG-DTA), these liquids were separately heated from room temperature to 800°C at a rate of 10°C/sec under atmospheric pressure and subjected to differential thermal analysis. The results of these measurements are shown in Fig. 1.

### <Evaluation Result 1>

As is clear from Fig. 1, as compared with the liquid composition of Synthesis Comparative Example 1, it was determined that the liquid composition of Synthesis Example 4 rapidly generated an exothermic reaction due to decomposition and oxidation at around 380°C. In addition to the carboxylic acid used in Synthesis Example 4, in a case where a carboxylic acid represented by General Formula CₙH₂ₙ₊₁COOH (here, 4≤n≤8) was used, a rapid exothermic reaction occurred in the same manner as Synthesis Example 4.

### <Comparative Test 2>

The denseness of the 20 types of KNN films obtained in Examples 1 to 13 and Comparative Examples 1 and Comparative Examples 4 to 9 was examined. The denseness of this KNN film was examined by measuring the density of the KNN film. Specifically, the cross-sections of 18 types of KNN films were observed by SEM, the cross-sectional images were image-analyzed to calculate the area of the film and the area of the void portion in the film, and the film density (%) was calculated by performing the calculation of [(film area-area of void portion)/film area]×100. A case of a film density of more than 98% was determined as "excellent", a case in a range of 90% to 97% was determined as "good", and a case of less than 90% was determined as "poor".

### <Evaluation Result 2>

As is clear from Table 3, in Comparative Example 1, the KNN film conditions were in a condition range in which a pre-fired film was formed by pre-firing at a temperature of 150°C or higher and 350°C or lower, and the pre-fired film was heated at a rate of 10°C/sec or more and fired at a temperature of 600°C or higher and 800°C or lower; however, a metal salt of the carboxylic acid represented by General Formula CₙH₂ₙ₊₁COOH (here, 4≤n≤8) was not used and a main solvent which is a carboxylic acid represented by General Formula CₙH₂ₙ₊₁COOH (here, 4≤n≤8) was also not used. In Comparative Examples 4 to 5, the KNN film conditions were in a condition range in which a pre-fired film was formed by pre-firing at a temperature of 150°C or higher and 350°C or lower, and the pre-fired film was heated at a rate of 10°C/sec or more and fired at a temperature of 600°C or higher and 800°C or lower; however, a metal salt of the carboxylic acid represented by General Formula CₙH₂ₙ₊₁COOH (here, 4≤n≤8) was not used with an organic potassium compound and an organic sodium compound. Therefore, it is considered that in Comparative Example 1 and Comparative Examples 4 to 5, a rapid exothermic reaction did not occur during the heating, and the amount of residual carbon increased, thus, a dense film was not formed.

In Comparative Examples 6 to 7, tests were performed using the liquid compositions obtained in Synthesis Example 7 in the same manner as Examples 7 and 10 to 13, but the KNN film-forming conditions were outside the range of conditions in which pre-firing was carried out at a temperature of 150°C or higher and 350°C or lower to form a pre-fired film and the pre-fired film was heated at a rate of 10°C/second or more and fired at a temperature of 600°C or higher and 800°C or lower. As a result, it was not possible to obtain a dense KNN film.

On the other hand, in Examples 1 to 13, a carboxylic acid represented by General Formula CₙH₂ₙ₊₁COOH (here, 4≤n≤8) was used as the main solvent, pre-firing was carried out at a temperature of 150°C or higher and 350°C or lower to form a pre-fired film, and the pre-fired film was heated at a rate of 10°C/sec or more and fired at a temperature of 600°C or higher and 800°C or lower. For this reason, a rapid exothermic reaction occurred during the heating, and due to this, a dense film was obtained. It is considered that the film increased in density due to a decrease in residual carbon due to the rapid exothermic reaction occurring during the heating.

### [Industrial Applicability]

It is possible to use the liquid composition for forming a KNN film and the KNN film obtained by the method for manufacturing the KNN film of the present invention for piezoelectric films for MEMS applications such as actuators, ultrasonic devices, vibration power generation elements, pyroelectric sensors, ink jet heads, and autofocusing.

## Claims

1. A liquid composition for forming a KNN film, comprising:
an organic metal compound including an organic potassium compound, an organic sodium compound, and an organic niobium compound; and
a solvent,
wherein each of the organic potassium compound and the organic sodium compound is a metal salt of a carboxylic acid represented by General Formula CₙH₂ₙ₊₁COOH (here, 4≤n≤8),
the organic niobium compound is a niobium alkoxide or a metal salt of a carboxylic acid represented by General Formula CₙH₂ₙ₊₁COOH (here, 4≤n≤8), and
a main solvent in the solvent is a carboxylic acid represented by General Formula CₙH₂ₙ₊₁COOH (here, 4≤n≤8) and a content of the main solvent is 50% by mass to 90% by mass with respect to 100% by mass of the liquid composition.

2. A method for forming a KNN film, comprising:
coating an electrode of a substrate with the liquid composition for forming a KNN film according to Claim 1, followed by performing pre-firing at a temperature of 150°C or higher and 350°C or lower to form a pre-fired film, and
heating the pre-fired film at a rate of 10°C/second or more to carry out firing at a temperature of 600°C or higher and 800°C or lower, thereby forming a crystallized KNN film.
